(19) Europäisches Patentamt
European Patent Office
Office européen des brevets

(11) **EP 4 697 384 A1**

(12) **EUROPEAN PATENT APPLICATION**
published in accordance with Art. 153(4) EPC

(43) Date of publication:
**18.02.2026 Bulletin 2026/08**

(21) Application number: **24788556.9**

(22) Date of filing: **26.03.2024**

(51) International Patent Classification (IPC):
**H01L 27/146** (2006.01)  **G02B 5/20** (2006.01)

(52) Cooperative Patent Classification (CPC):
**G02B 5/20; H10F 39/12**

(86) International application number:
**PCT/JP2024/011880**

(87) International publication number:
**WO 2024/214528 (17.10.2024 Gazette 2024/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **10.04.2023 JP 2023063246**

(71) Applicant: **Sony Semiconductor Solutions
Corporation
Atsugi-shi, Kanagawa 243-0014 (JP)**

(72) Inventors:
• **MIURA, Mariko
Atsugi-shi, Kanagawa 243-0014 (JP)**

• **OZAKI, Kosuke
Kikuchi-gun, Kumamoto 869-1102 (JP)**
• **NISHI, Sachio
Kikuchi-gun, Kumamoto 869-1102 (JP)**
• **YAGAI, Tomoki
Atsugi-shi, Kanagawa 243-0014 (JP)**
• **ITO, Kyosuke
Atsugi-shi, Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(54) **LIGHT DETECTION ELEMENT**

(57) The present disclosure relates to a light detection element that can suppress a sensitivity difference between pixels in an image sensor having a PDAF structure. The light detection element of the present disclosure includes a pixel array unit formed by an arrangement of pixels that constitute, for every n × n pixels, a pixel group including color filters of the same color, two or more phase difference detection pixels adjacent to each other, the two or more phase difference detection pixels being provided in place of some of normal pixels arranged in the pixel array unit, and a light shielding portion provided for each of the pixel groups constituted by the normal pixels, including surrounding pixels disposed around the phase difference detection pixels, the light shielding portion differing in width or shape depending on an image height. The present disclosure is applicable to, for example, a CMOS image sensor.

Fig.7

EP 4 697 384 A1

## Description

Technical Field

The present disclosure relates to a light detection element, and more particularly, to a light detection element that can suppress the sensitivity difference between pixels in an image sensor having a PDAF structure.

Background Art

PTL 1 discloses a solid-state imaging device that adjusts the sensitivity of pixels by varying, depending on an image height, an opening portion of a light shielding film formed in an upper layer relative to a photoelectric conversion unit, thereby improving image quality even with a screen distribution in which correction of a Gr/Gb step difference, color shading, or the like is complicated.

In addition, PTL 2 discloses a solid-state imaging device that, with respect to color mixing caused by pupil correction, suppresses the occurrence of a color mixing path by changing the line width of a light shielding film depending on the correction amount for pupil correction, that is, the image height.

Citation List

Patent Literature

PTL 1: JP 2017-059739 A
PTL 2: JP 2023-002902 A

Summary

Technical Problem

In the related art, an image sensor is known that includes normal pixels and phase difference detection pixels and that has a phase detection auto focus (PDAF) structure in which one shared on-chip lens is formed for a plurality of phase difference detection pixels. However, in the above-described patent literature, no consideration has been given to an image sensor having a PDAF structure.

The present disclosure has been made in view of such circumstances and is intended to enable suppression of the sensitivity difference between pixels in an image sensor having a PDAF structure.

Solution to Problem

A light detection element of the present disclosure is a light detection element including a pixel array unit formed by an arrangement of pixels that constitute, for every n × n pixels (n is a natural number of two or more), a pixel group including color filters of the same color, two or more phase difference detection pixels adjacent to each other, the two or more phase difference detection pixels being provided in place of some of normal pixels arranged in the pixel array unit, and a light shielding portion provided for each of the pixel groups constituted by the normal pixels, including surrounding pixels disposed around the phase difference detection pixels, the light shielding portion differing in width or shape depending on the image height.

In the present disclosure, the pixel array unit is formed by the arrangement of pixels that constitute, for every n × n pixels, a pixel group including color filters of the same color, two or more phase difference detection pixels adjacent to each other are provided in place of some of normal pixels arranged in the pixel array unit, and a light shielding portion differing in width or shape depending on an image height is provided for each of the pixel groups constituted by the normal pixels, including the surrounding pixels disposed around the phase difference detection pixels.

Brief Description of Drawings

[Fig. 1]

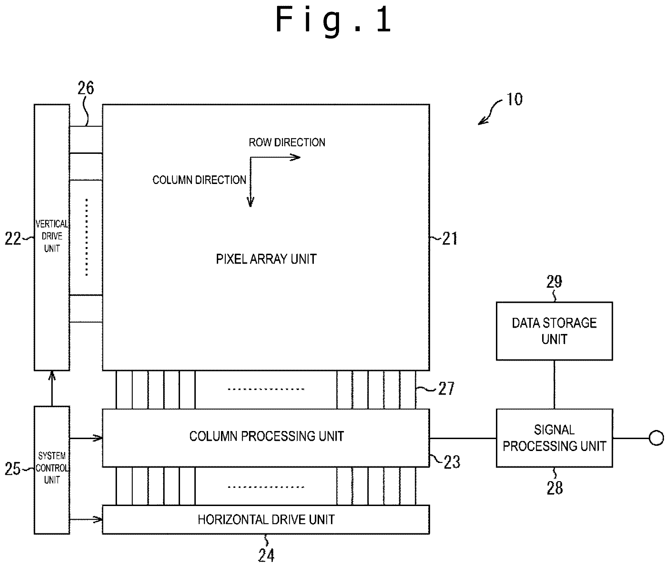

Fig. 1 is a diagram illustrating a configuration example of a CMOS image sensor.

[Fig. 2]

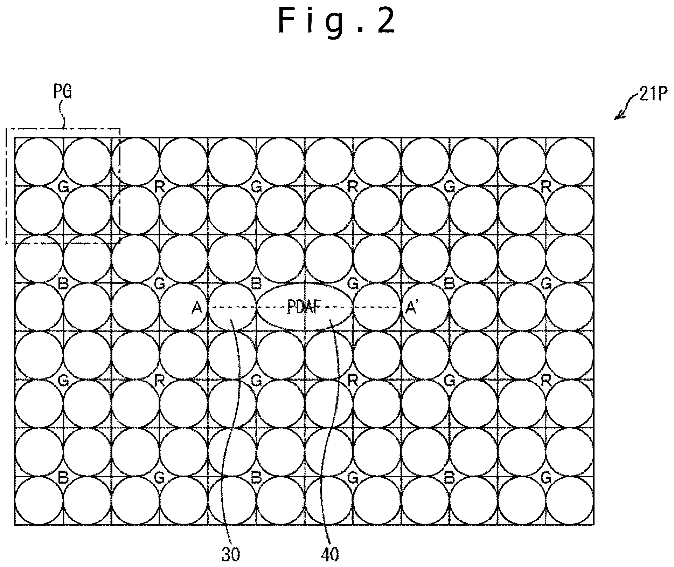

Fig. 2 is a top view illustrating a configuration example of a pixel array unit.
[Fig. 3]

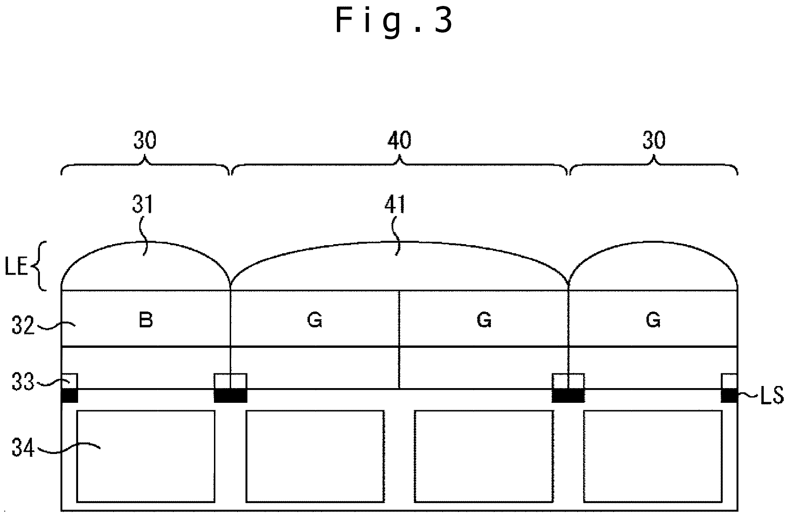

Fig. 3 is a diagram illustrating a cross-sectional configuration example of normal pixels and phase difference detection pixels.
[Fig. 4]

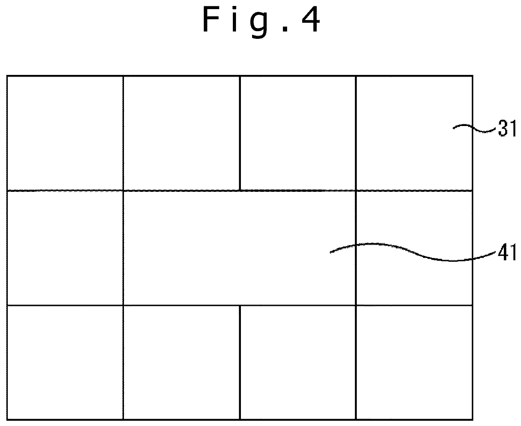

Fig. 4 is a top view illustrating an example of a shared on-chip lens.
[Fig. 5]

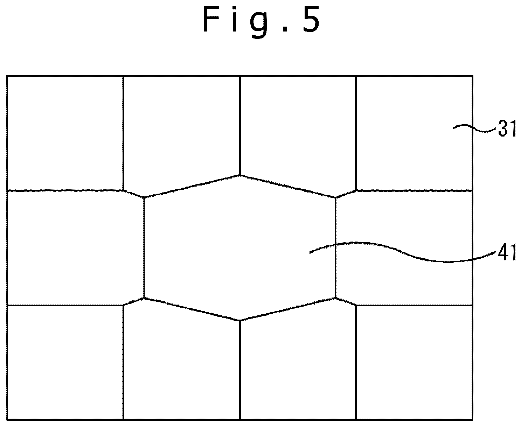

Fig. 5 is a top view illustrating an example of the shared on-chip lens.
[Fig. 6]

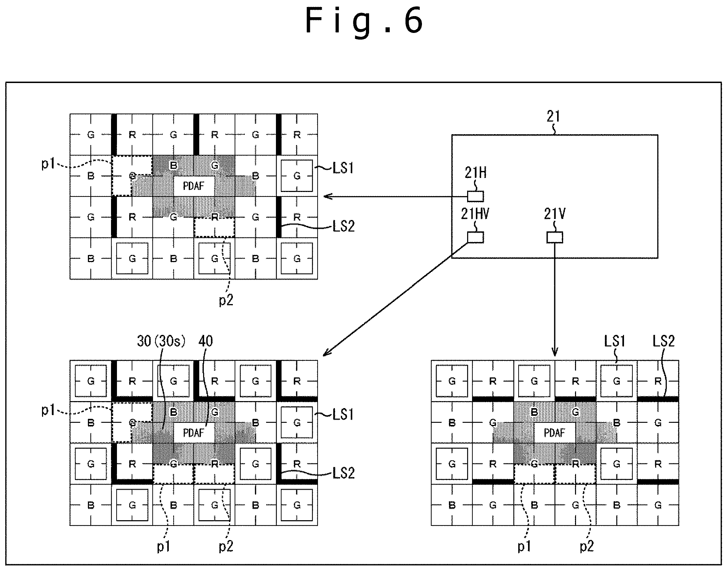

Fig. 6 is a diagram for describing a problem when a light shielding film is not applied to surrounding pixels.
[Fig. 7]

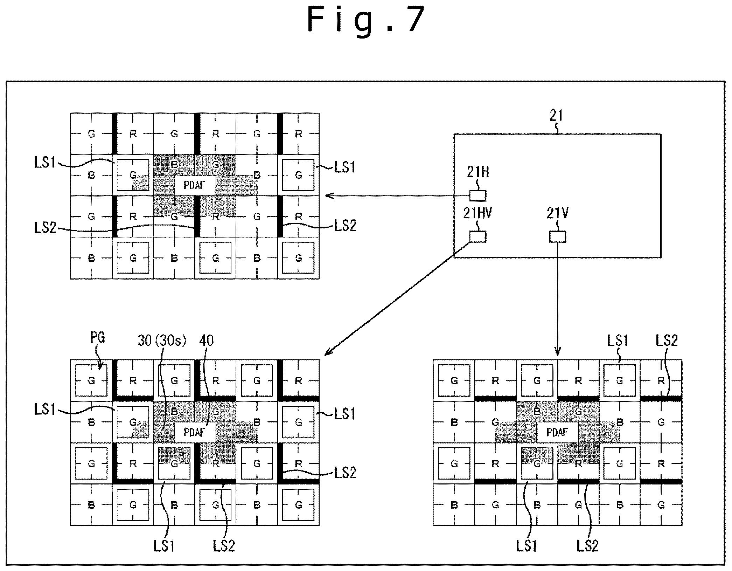

Fig. 7 is a diagram illustrating a configuration example of a pixel array unit according to a first embodiment of the present disclosure.
[Fig. 8]

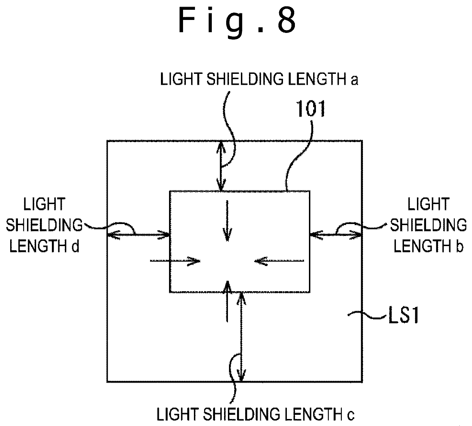

Fig. 8 is a diagram illustrating an example of a first light shielding film.
[Fig. 9]

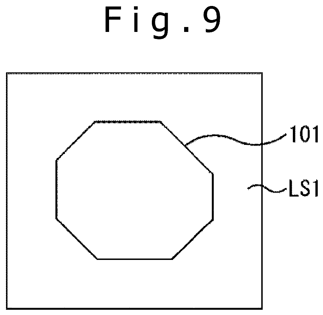

Fig. 9 is a diagram illustrating an example of the first light shielding film.
[Fig. 10]

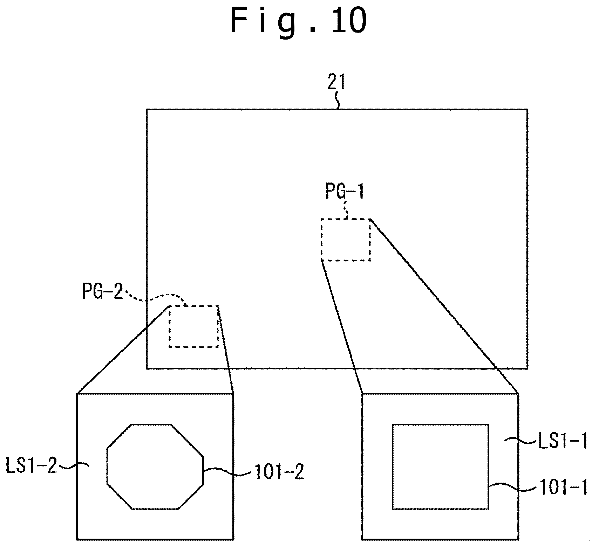

Fig. 10 is a diagram illustrating an example of change in the first light shielding film dependent on an image height.
[Fig. 11]

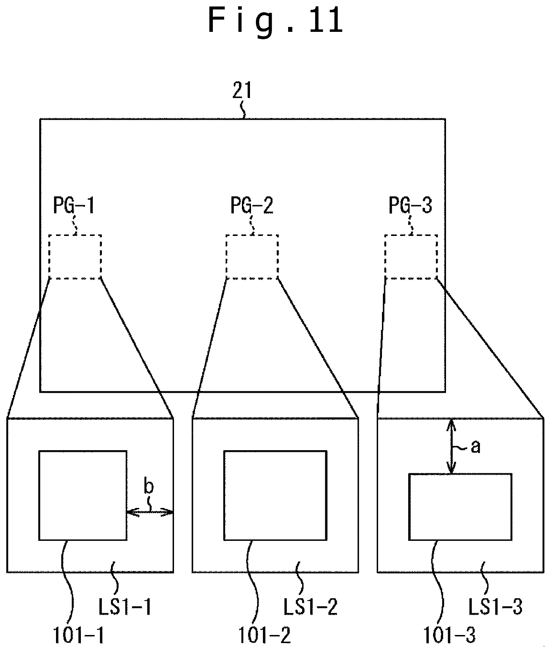

Fig. 11 is a diagram illustrating an example of change in the first light shielding film dependent on the image height.
[Fig. 12]

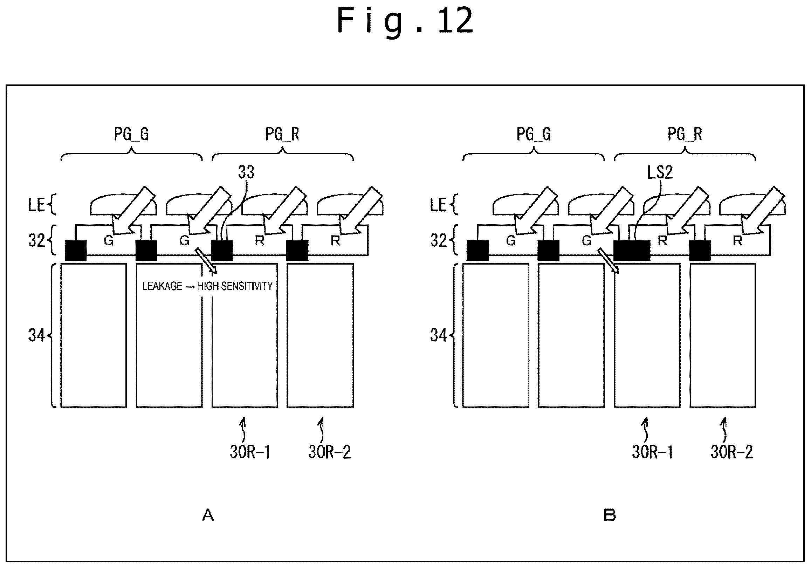

Fig. 12 is a diagram for describing the structure of a second light shielding film.
[Fig. 13]

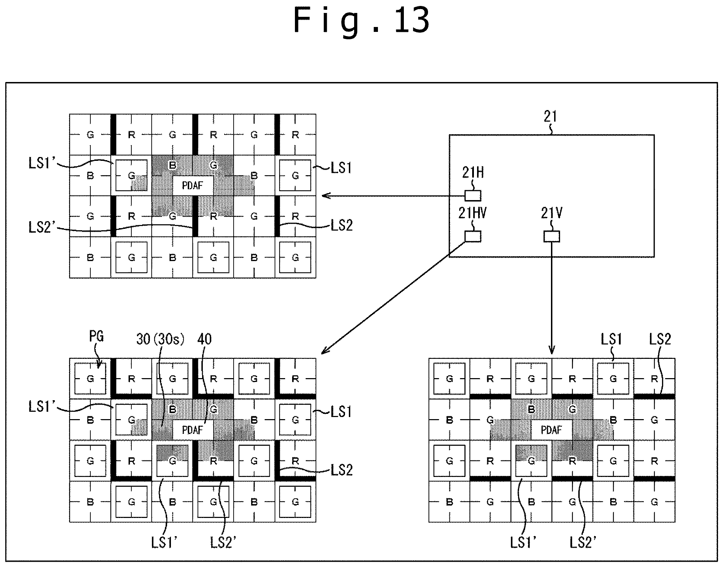

Fig. 13 is a diagram illustrating a configuration example of a pixel array unit according to a second embodiment of the present disclosure.
[Fig. 14]

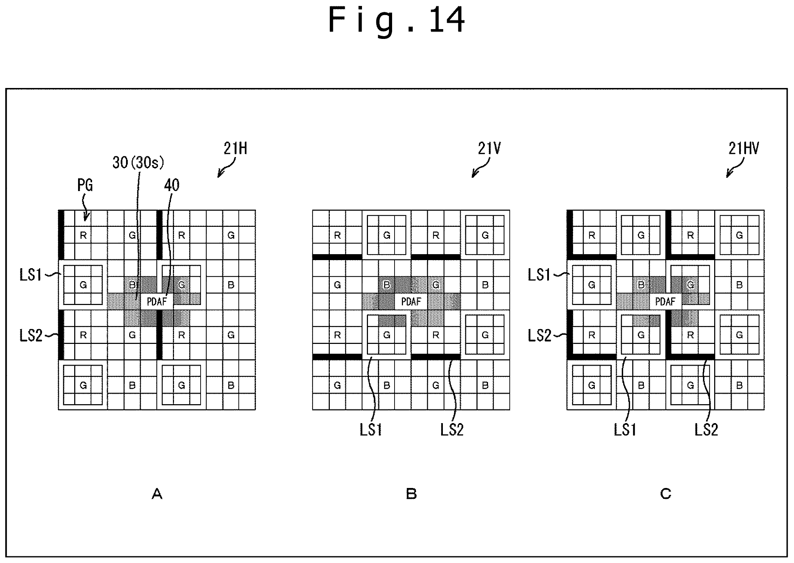

Fig. 14 is a diagram illustrating a configuration example of a pixel array unit according to a third embodiment of the present disclosure.
[Fig. 15]

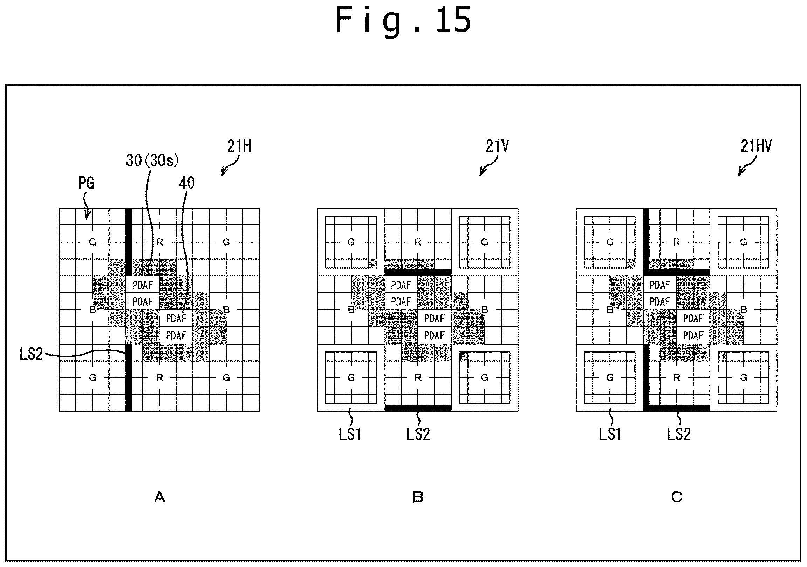

Fig. 15 is a diagram illustrating a configuration example of a pixel array unit according to a fourth embodiment of the present disclosure.
[Fig. 16]

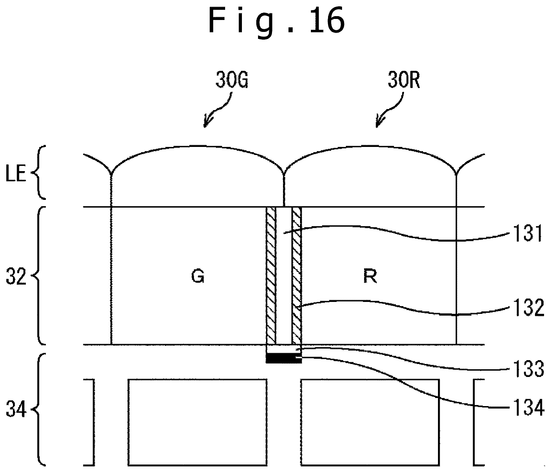

Fig. 16 is a diagram illustrating a configuration example of a pixel array unit according to a fifth embodiment of the present disclosure.
[Fig. 17]

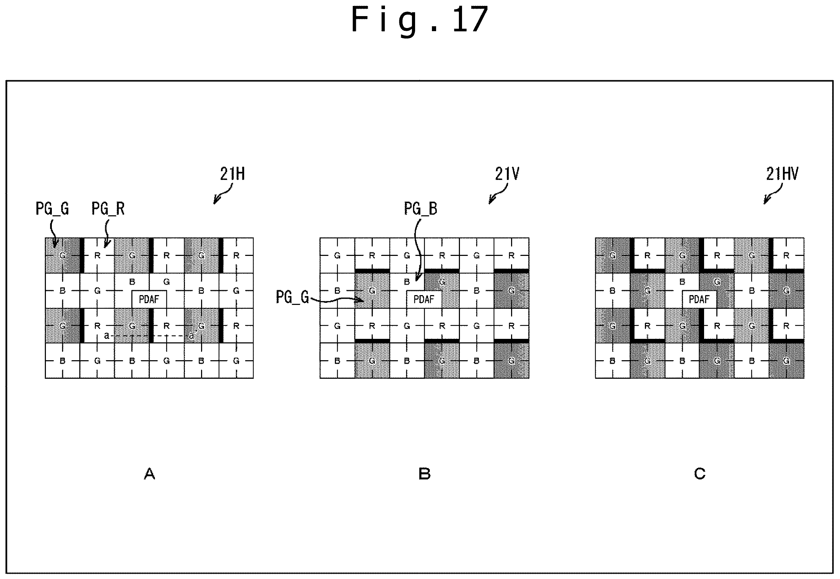

Fig. 17 is a diagram illustrating a configuration example of a pixel array unit according to a sixth embodiment of the present disclosure.
[Fig. 18]

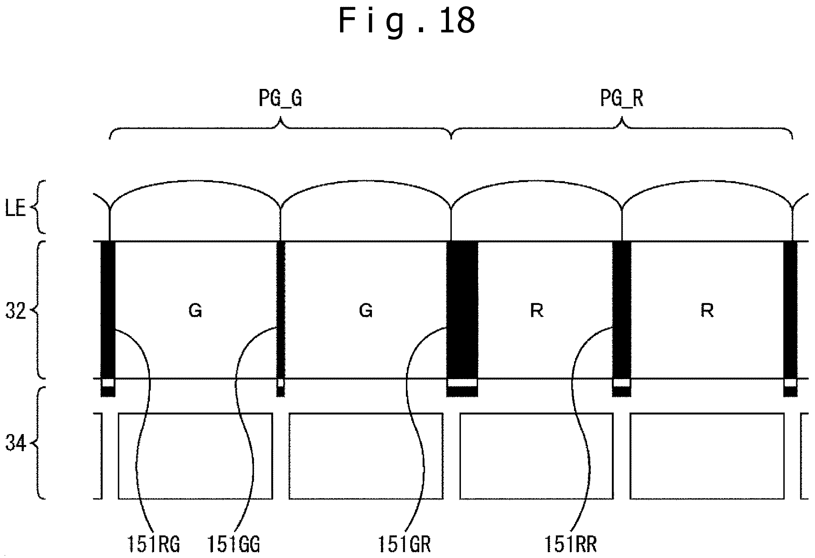

Fig. 18 is a diagram illustrating a cross-sectional configuration example of a part of a pixel region.
[Fig. 19]

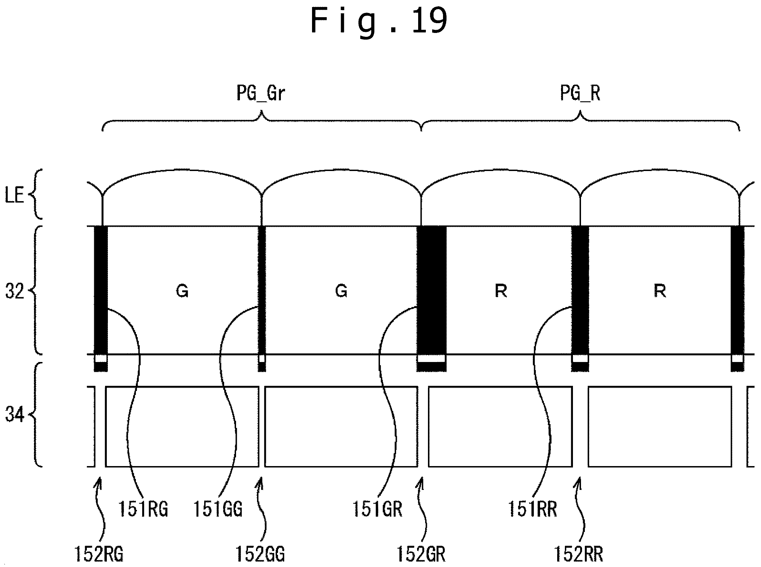

Fig. 19 is a diagram illustrating another cross-sectional configuration example of a part of the pixel region.

Description of Embodiments

Hereinafter, modes for carrying out the present disclosure (hereinafter, referred to as embodiments) will be described. The descriptions will be given in the following order.
1. Configuration Example of CMOS Image Sensor
2. PDAF Structure and Application of Image-Height-Dependent Light Shielding Portion
3. First Embodiment (Pixel Array Unit of 2 × 2 Pixels)
3-1. First Light Shielding Film for Correcting Gr/Gb Ratio
3-2. Second Light Shielding Film for Correcting Intra-Color Sensitivity Difference
4. Second Embodiment (Light Shielding Characteristics of Light Shielding Portion in Pixel Group Including Surrounding Pixels)
5. Third Embodiment (Pixel Array Unit of 3 × 3 Pixels)

6. Fourth Embodiment (Pixel Array Unit of 4 × 4 Pixels)
7. Fifth Embodiment (Configuration Including Waveguide)
8. Sixth Embodiment (Configuration for Increasing Sensitivity of Green Pixel Group)

1. Configuration Example of CMOS Image Sensor

A technology according to the present disclosure is a technology related to a light detection element including a pixel array unit formed by an arrangement of pixels constituting, for every n × n pixels (n is a natural number of two or more), a pixel group including color filters of the same color. The pixel array unit includes normal pixels and phase difference detection pixels and has a phase detection auto focus (PDAF) structure in which one shared on-chip lens is formed for a plurality of phase difference detection pixels.

Fig. 1 is a diagram illustrating a configuration example of a complementary metal oxide semiconductor (CMOS) image sensor that is a light detection element to which the technology according to the present disclosure is applied.

A CMOS image sensor 10 is, for example, a back-illuminated solid-state imaging device, and includes a pixel array unit 21 formed on a semiconductor substrate (chip) (not illustrated) and a peripheral circuit unit integrated on the same semiconductor substrate as the pixel array unit 21.

The peripheral circuit unit includes, for example, a vertical drive unit 22, a column processing unit 23, a horizontal drive unit 24, and a system control unit 25.

The CMOS image sensor 10 includes a signal processing unit 28 and a data storage unit 29. The signal processing unit 28 and the data storage unit 29 may be provided on the semiconductor substrate constituting the CMOS image sensor 10, or may be provided on a substrate different from the semiconductor substrate constituting the CMOS image sensor 10.

The pixel array unit 21 has a configuration in which a plurality of unit pixels (hereinafter, also simply referred to as pixels) each including a photoelectric conversion unit that generates and accumulates an electric charge corresponding to the amount of received light are arranged in a row direction and a column direction, that is, two-dimensionally in a matrix.

Here, the row direction is an array direction (horizontal direction) of pixels in a pixel row, that is, the lateral direction in the drawing, and the column direction is an array direction (vertical direction) of pixels in a pixel column, that is, the longitudinal direction in the drawing.

In the pixel array unit 21, a pixel drive line 26 is wired to the matrix-shaped pixel array for each pixel row along the row direction, and a vertical signal line 27 is wired to the matrix-shaped pixel array for each pixel column along the column direction. The pixel drive line 26 is a signal line for supplying a drive signal (control signal) for driving a pixel, such as driving for reading out a signal from the pixel. One end of the pixel drive line 26 is connected to an output end corresponding to each row of the vertical drive unit 22.

Here, for better visualization of the drawing, one pixel drive line 26 is depicted per pixel row, but in practice, a plurality of pixel drive lines 26 are wired per pixel row.

The vertical drive unit 22 includes, for example, a shift register, an address decoder, and the like, and drives the pixels of the pixel array unit 21 all at once, on a row-by-row basis, or the like. For example, the vertical drive unit 22 includes two scanning systems, namely a readout scanning system and a sweep scanning system.

The readout scanning system sequentially selects and scans the unit pixels of the pixel array unit 21 on a row-by-row basis to read out signals from the unit pixels.

The sweep scanning system performs sweep scanning at a predetermined timing on the readout row on which the readout scanning is performed by the readout scanning system. The sweep scanning by the sweep scanning system sweeps out unnecessary electric charges from the photoelectric conversion units of the unit pixels in the readout row, thereby resetting the photoelectric conversion units.

For each pixel column, a signal output from a corresponding unit pixel in the pixel row selected and scanned by the vertical drive unit 22 is input to the column processing unit 23 via the vertical signal line 27.

For each pixel column of the pixel array unit 21, the column processing unit 23 performs predetermined signal processing on the signal supplied from the corresponding pixel in the selected row via the vertical signal line 27, and temporarily holds the pixel signal after the signal processing.

For example, the column processing unit 23 performs, as the signal processing, noise removal processing, correlated double sampling (CDS) processing, analog to digital (AD) conversion processing, and the like. For example, the CDS processing removes fixed pattern noise unique to each pixel, such as reset noise and a variation in a threshold value of an amplification transistor in the pixel.

The horizontal drive unit 24 includes a shift register, an address decoder, and the like, and sequentially selects unit circuits, corresponding to the pixel columns, of the column processing unit 23. By the selective scanning by the horizontal drive unit 24, the pixel signals that have been subjected to the signal processing for each unit circuit in the column processing unit 23 are sequentially output to the signal processing unit 28.

The system control unit 25 includes a timing generator that generates various timing signals, and the like, and performs drive control of the vertical drive unit 22, the column processing unit 23, the horizontal drive unit 24, and the like based on the generated timing signals.

The signal processing unit 28 has at least an arithmetic processing function, and performs various types of signal processing such as arithmetic processing on the pixel signal output from the column processing unit 23. When the signal processing unit 28 performs the signal processing, the data storage unit 29 temporarily stores the data necessary for the processing.

2. PDAF Structure and Application of Image-Height-Dependent Light Shielding Portion

PDAF Structure

As described above, the CMOS image sensor 10 includes normal pixels and phase difference detection pixels and has a PDAF structure in which one shared on-chip lens is formed for a plurality of phase difference detection pixels.

Fig. 2 is a top view in which a partial pixel region 21P including phase difference detection pixels is extracted from the pixel array unit 21 included in the CMOS image sensor 10. Fig. 3 is a diagram illustrating a cross-sectional configuration example taken along line segment A-A' in Fig. 2.

In the pixel region 21P, normal pixels 30 are arranged in a matrix, and two or more phase difference detection pixels 40 adjacent to each other are provided in place of some of the normal pixels 30. In the pixel array unit 21 including the pixel region 21P, the normal pixels 30 constitute, for every n × n pixels (n = 2 in the example in Fig. 2), a pixel group PG including color filters of the same color. That is, in the pixel array unit 21, color filters colored in any of red (R), green (G), and blue (B) and disposed according to, for example, the Bayer array are formed so as to cover each pixel group PG.

As illustrated in Fig. 3, each normal pixel 30 is constituted by, in order from the upper surface side (incident surface side), an individual on-chip lens 31, a color filter 32, an inter-pixel light shielding structure 33, and a photoelectric conversion unit 34.

The individual on-chip lens 31 is formed for each pixel in an on-chip lens layer LE in order to more efficiently cause incidence of incident light on the photoelectric conversion unit 34 in a lower layer. The color filter 32 is formed as a color filter of a color corresponding to the pixel group PG including the pertinent normal pixel 30, the color filter enabling a specific wavelength of the incident light to pass therethrough toward a lower layer.

The inter-pixel light shielding structure 33 is formed of a metal material or the like in order to reduce optical color mixing between adjacent pixels. The photoelectric conversion unit 34 includes a photodiode that generates and accumulates an electric charge according to incident light incident through the individual on-chip lens 31 and the color filter 32. Although not illustrated, a signal wiring layer for reading out the signal electric charge generated and accumulated by the photoelectric conversion unit 34 and for outputting the signal electric charge to a subsequent stage is formed in a layer below the photoelectric conversion unit 34. In addition, a light shielding film LS as a light shielding portion to which the technology according to the present disclosure can be applied is provided below the inter-pixel light shielding structure 33.

On the other hand, the phase difference detection pixel 40 is constituted by, in order from the upper surface side (incident surface side), a shared on-chip lens 41 formed in the on-chip lens layer LE, the color filter 32, the inter-pixel light shielding structure 33, and the photoelectric conversion unit 34. Note that the color filters constituting the phase difference detection pixels 40 are all green color filters.

Fig. 4 is a top view illustrating an example of the shared on-chip lens 41.

As illustrated in Fig. 4, the shared on-chip lens 41 is formed so as to cover the plurality of (two in the example in Fig. 4) phase difference detection pixels 40 that are adjacent to each other. That is, the configuration example illustrated in Figs. 2 and 3 has a configuration in which two phase difference detection pixels 40 share the shared on-chip lens 41.

Note that the inter-pixel light shielding structure 33 formed between the normal pixels 30 and between the normal pixels 30 and the phase difference detection pixels 40 is not formed between the plurality of phase difference detection pixels 40 sharing the shared on-chip lens 41. However, the inter-pixel light shielding structure 33 may be formed between the plurality of phase difference detection pixels 40 sharing the shared on-chip lens 41.

In the CMOS image sensor 10 including the normal pixels 30 and the phase difference detection pixels 40, high resolution and high image quality of a captured image can be achieved by the normal pixels 30. In addition, since the phase difference detection pixels 40 perform phase difference detection with the light collecting power of the shared on-chip lens 41 without blocking light with the light shielding structure, it is possible to perform phase difference detection with high sensitivity and good separation ratio characteristics. Further, since there is no obstacle that scatters or diffracts light in an optical path, color mixing of adjacent pixels that may occur due to scattering or diffraction of light is suppressed, and thus deterioration of image quality can be prevented.

Fig. 5 is a top view illustrating another example of the shared on-chip lens 41.

When the shared on-chip lens 41 is formed by the same manufacturing method as that for the individual on-chip lens 31, the individual on-chip lens 31 fills a plane with almost no gaps between adjacent pixels, and the shape thereof is substantially quadrangular. In contrast, the shared on-chip lens 41 in Fig. 5 has a substantially hexagonal shape.

Accordingly, it is possible to increase the sensitivity of the phase difference detection pixels 40, without a gap being formed between the light collecting element structures (on-chip lenses) of the normal pixels 30 and the phase difference detection pixels 40.

Application of Image-Height-Dependent Light Shielding Portion

Fig. 6 illustrates a top view with extracted pixel regions 21H, 21V, and 21HV located toward ends of the image height away from the center position in a light receiving surface of the pixel array unit 21, that is, the center of the image height.

The pixel region 21H is a pixel region located horizontally leftward from the position of the center of the image height of the pixel array unit 21, and the pixel region 21V is a pixel region located vertically downward from the position of the center of the image height of the pixel array unit 21. The pixel region 21HV is a pixel region located toward the lower left in a diagonal direction from the position of the center of the image height of the pixel array unit 21.

In all of the pixel regions 21H, 21V, and 21HV, the phase difference detection pixels 40 are included in addition to the normal pixels 30. As described above, since the phase difference detection pixels 40 include green color filters, a pixel group (hereinafter, referred to as a green pixel group or the like) that includes green color filters and that is adjacent to the phase difference detection pixels 40 is constituted by five pixels, and a blue pixel group adjacent to the phase difference detection pixels 40 is constituted by three pixels.

In addition, in the pixel regions 21H, 21V, and 21HV, surrounding pixels 30s disposed around the phase difference detection pixels 40 are illustrated with gray coloring. The surrounding pixels 30s include, in addition to ten pixels adjacent to and surrounding the phase difference detection pixels 40, two pixels further adjacent to the two pixels adjacent to the phase difference detection pixels 40 in the horizontal direction (left and right directions, respectively).

Here, application of an image-height-dependent light shielding portion to the above-described pixel array unit 21 including pixel groups of 2 × 2 pixels and having a PDAF structure will be considered.

As illustrated in Fig. 6, in the pixel regions 21H, 21V, and 21HV, a first light shielding film LS1 and a second light shielding film LS2 are provided as light shielding portions differing in width or shape depending on the image height, for each pixel group including color filters of the same color.

Although the detailed configuration will be described below, the first light shielding film LS1 is a light shielding member that is formed in a green pixel group and that is for correcting the sensitivity ratio (hereinafter referred to as a Gr/Gb ratio) of the green pixel group adjacent to a red pixel group and of the green pixel group adjacent to a blue pixel group in the row direction. The first light shielding film LS1 is formed so as to make an adjustment to decrease the sensitivity of the green pixel group adjacent to the blue pixel group when viewed from the center of the image height. It suffices for the first light shielding film LS1 to be formed between the on-chip lens layer LE and the photoelectric conversion unit 34 of each pixel constituting the green pixel group.

The second light shielding film LS2 is a light shielding member that is formed in a red pixel group and that is for correcting the sensitivity difference between the pixels constituting the red pixel group (hereinafter, intra-color sensitivity difference). The second light shielding film LS2 is formed so as to cancel out the sensitivity corresponding to leakage of incident light from the green pixel group adjacent to the red pixel group. It suffices for the second light shielding film LS2 to be formed between the on-chip lens layer LE and the photoelectric conversion unit 34 of each pixel constituting the red pixel group.

Here, in each of the pixel regions 21H, 21V, and 21HV, the surrounding pixels 30s are adjacent to the phase difference detection pixels 40 and thus may have output characteristics different from those of the normal pixels 30 not adjacent to the phase difference detection pixels 40. Therefore, as illustrated in Fig. 6, in each of the pixel regions 21H, 21V, and 21HV, the image-height-dependent light shielding portion (first light shielding film LS1 or second light shielding film LS2) is not provided to the pixel groups including the surrounding pixels 30s.

However, in this case, the pixel groups including the surrounding pixels 30s are relatively more sensitive than surrounding pixel groups of the same color.

Specifically, in each of the pixel regions 21H, 21V, and 21HV, pixels p1 in the green pixel groups including the surrounding pixels 30s are more sensitive than the normal pixels 30 constituting the surrounding green pixel groups. Moreover, in each of the pixel regions 21H, 21V, and 21HV, pixels p2 in the red pixel group including the surrounding pixels 30s are more sensitive than the other normal pixels 30 constituting the same red pixel group.

As a result, the pixel groups including the surrounding pixels 30s are detected as high-luminance pixel groups (hereinafter referred to as a bright spot) having a larger light amount than the other pixel groups.

Therefore, the light detection element to which the technology according to the present disclosure is applied is provided with the light shielding portion differing in width or shape depending on the image height, for each of the pixel groups constituted by the normal pixels, including the surrounding pixels disposed around the phase difference detection pixels.

3. First Embodiment (Pixel Array Unit of 2 × 2 Pixels)

Fig. 7 is a diagram illustrating a configuration example of the pixel array unit 21 according to a first embodiment of the present disclosure.

In a manner similar to Fig. 6, Fig. 7 illustrates a top view with extracted pixel regions 21H, 21V, and 21HV located toward ends of the image height away from the center position in a light receiving surface of the pixel array unit 21, that is, the center of the image height.

However, unlike Fig. 6, in each of the pixel regions 21H, 21V, and 21HV illustrated in Fig. 7, the image-height-dependent light shielding portion (first light shielding film LS1 or second light shielding film LS2) is also provided to pixel groups including the surrounding pixels 30s. Note that the image-height-dependent light shielding portion (first light shielding film LS1 or second light shielding film LS2) is not provided to the phase difference detection pixels 40.

According to the above configuration, it is possible to suppress the sensitivity difference between the pixel groups including the surrounding pixels 30s and surrounding pixel groups of the same color not including the surrounding pixels 30s. As a result, it is possible to prevent each of the pixel groups including the surrounding pixels 30s from being detected as a bright spot having a larger light amount than the other pixel groups.

Here, the first light shielding film LS1 and the second light shielding film LS2 will be described in detail.

3-1. First Light Shielding Film for Correcting Gr/Gb Ratio

Fig. 8 is a diagram illustrating an example of the first light shielding film LS1 for one pixel group.

The first light shielding film LS1 is formed in a rectangular shape so as to cover the pixel group, and includes an opening portion 101 in the interior thereof. As illustrated in Fig. 8, the length from the upper side of the first light shielding film LS1 to the upper side of the opening portion 101 is a light shielding length a, and the length from the right side of the first light shielding film LS1 to the right side of the opening portion 101 is a light shielding length b. The length from the lower side of the first light shielding film LS1 to the lower side of the opening portion 101 is a light shielding length c, and the length from the left side of the first light shielding film LS1 to the left side of the opening portion 101 is a light shielding length d.

When light is collected at the center of the opening portion 101, the first light shielding film LS1 can decrease the sensitivity by moving any side to the center. That is, in order to make an adjustment to decrease the sensitivity, it is not necessary to simultaneously move all the sides, and the adjustment can be made by moving only a specific side. In this manner, by treating each side individually as an adjustment parameter, the adjustment parameter can be adjusted for each pixel group, and the opening portion can be represented by the ratio of side lengths that differs depending on the image height, and by the shape associated therewith. Therefore, a complicated distribution within the angle of view can be corrected.

Although detailed description is omitted, in the technology according to the present disclosure, correction is individually performed by setting a parameter for correcting the distribution of the Gr/Gb ratio increasing from the left to the right, depending on the image height, as the light shielding length a, a parameter for correcting the distribution increasing from the right to the left as the light shielding length b, a parameter for correcting the distribution increasing from the bottom to the top as the light shielding length c, and a parameter for correcting the distribution increasing from the top to the bottom as the light shielding length d. As a result, the opening portion 101 is formed by a combination of the light shielding lengths a to d, and thus it is possible to correct a complicated shape of the distribution of the Gr/Gb ratio.

These light shielding lengths may be corrected by coordinates based on the following Equations (1) to (4), for example. Here, A to L are given constants, and x and y within the angle of view indicate coordinates in the lateral direction and the longitudinal direction, respectively.

$$\text{Light shielding length a} = Ay^2 + By + C \quad (1)$$

$$\text{Light shielding length b} = Dx^2 + Ex + F \quad (2)$$

$$\text{Light shielding length c} = Gy^2 + Hy + I \quad (3)$$

$$\text{Light shielding length d} = Jx^2 + Kx + L \quad (4)$$

In Equations (1) to (4) described above, the distribution in the lateral direction is canceled out by the light shielding lengths b and d, and the distribution in the longitudinal direction is canceled out by the light shielding lengths a and c, but these assignments and equations are arbitrary, and need not be as described above. For example, an equation may be a cubic equation or a quartic equation, or the same equation may simultaneously have both of the parameters x and y (for example, the light shielding length a = Ay$^2$ + Bxy + Cy$^2$ + D, or the like). The shape need not be changed linearly and may be changed non-linearly.

Since the light shielding lengths are individually controlled, the opening ratio may change, but the opening ratio may not necessarily change. For example, even when the light shielding length a is increased, the opening ratio is maintained if the light shielding length b is decreased (that is, even when the shape is changed). In addition, when the contribution ratios of the light shielding length a, the light shielding length b, and the like, to the sensitivity are different, changes may be made without changing the opening ratio.

With size reduction of pixels, the opening width and the light wavelength size become closer to each other. If the opening ratio is changed too easily, the wavelengths that can pass through are restricted, affecting the spectral characteristics. However, the approach of the technology according to the present disclosure allows for sensitivity adjustment while maintaining the opening ratio. Of course, the opening ratio may also be changed.

To enable a more complex adjustment, it suffices to increase the number of "sides" described with reference to Fig. 8. For example, as illustrated in Fig. 9, the opening portion 101 of the first light shielding film LS1 may be formed in an octagonal shape. Further, as illustrated in Fig. 10, an opening portion 101-1 is formed in a rectangular shape in a first light shielding film LS1-1 of a pixel group PG-1 at the center of the image height, but the number of sides may be increased depending on the image height, and an opening portion 101-2 may be formed in a polygonal shape having five or more corners (for example, an octagonal shape) in a first light shielding film LS1-2 of a pixel group PG-2. Of course, the number of sides may be decreased according to the image height.

As illustrated in Fig. 11, sides to be changed may be limited depending on the image height or the quadrant. In the example in Fig. 11, an opening portion 101-2 having the same width on all four sides is formed in a pixel group PG-2 at the center of the image height. In contrast, only the light shielding length b is changed in a pixel group PG-1 on the left side of the quadrant, and only the light shielding length a is changed in a pixel group PG-2 on the right side of the quadrant. In addition, the light shielding film disclosed in PTL 1 can be applied to the first light shielding film LS1 as necessary.

In this manner, the ratio of side lengths and the shape of the opening portion 101 can be made to differ depending on the image height. That is, the Gr/Gb ratio can be adjusted for each pixel group, and the adjustment can be made for each color (Gr/Gb, that is, the color of the color filter of an adjacent pixel group adjacent to the pixel group).

3-2. Second Light Shielding Film for Correcting Intra-Color Sensitivity Difference

Fig. 12 is a diagram for describing the structure of the second light shielding film LS2.

Fig. 12 illustrates a cross-sectional view of four of the pixels constituting a green pixel group PG_G and a red pixel group PG_R adjacent to each other. In the example in Fig. 12, the center of the image height is on the right side in the drawing.

As illustrated in A in Fig. 12, in the configuration in which the second light shielding film LS2 is not formed, the inter-pixel light shielding structure 33 formed between the adjacent normal pixels is present between the green pixel group PG_G and the red pixel group PG_R.

In such a configuration, when light is incident on each normal pixel, light could leak from a normal pixel that is in the green pixel group PG_G and adjacent to the red pixel group PG_R into a normal pixel 30R-1 constituting the red pixel group PG_R, depending on the correction amount for pupil correction. In this case, the normal pixel 30R-1 becomes more sensitive than a normal pixel 30R-2 constituting the same red pixel group PG_R.

Therefore, in one pixel group, the second light shielding film LS2 is formed in a normal pixel located far from the center of the image height, among normal pixels adjacent to another pixel group. That is, as illustrated in B in Fig. 12, the second light shielding film LS2 is formed in the normal pixel 30R-1 that is in the red pixel group GP_R and adjacent to the green pixel group PG_G. At this time, in the red pixel group GP_R, the second light shielding film LS2 is formed to extend along the boundary with the green pixel group PG_G. Note that it suffices to adjust the width of the second light shielding film LS2 based on the correction amount for pupil correction, that is, the amount of light leaking from the green pixel group PG_G to the normal pixel 30R-1 depending on the image height.

With this configuration, by suppressing the incidence of light on the normal pixel 30R-1, it is possible to cancel out the sensitivity corresponding to the leakage of the incident light from the green pixel group PG_G. As a result, it is possible to suppress the intra-color sensitivity difference between the normal pixel 30R-1 and the normal pixel 30R-2 in the red pixel group GP_R.

4. Second Embodiment (Light Shielding Characteristics of Light Shielding Portion in Pixel Group Including Surrounding Pixel)

Fig. 13 is a diagram illustrating a configuration example of the pixel array unit 21 according to a second embodiment of the present disclosure.

As in Fig. 7 illustrating the pixel array unit 21 according to the first embodiment, Fig. 13 illustrates a top view with extracted pixel regions 21H, 21V, and 21HV located toward ends of the image height away from the center position in a light receiving surface of the pixel array unit 21, that is, the center of the image height.

However, unlike Fig. 7, in each of the pixel regions 21H, 21V, and 21HV illustrated in Fig. 13, a pixel group including the surrounding pixel 30s is provided with a light shielding portion (first light shielding film LS1' or second light shielding film LS2') having a light shielding characteristic different from that in a pixel group present at the same image height and not including the surrounding pixels 30s.

Unlike the first light shielding film LS1 and the second light shielding film LS2 provided to the pixel groups not including the surrounding pixels 30s, the first light shielding film LS1' and the second light shielding film LS2' have light shielding characteristics corresponding to the output characteristics of the surrounding pixels 30s. The light shielding characteristics mentioned here are characteristics that directly contribute to the Gr/Gb ratio and the correction amount for the intra-color sensitivity difference, and may be the width, shape, material, or the like of the light shielding member.

According to the above configuration, even when signals output from the surrounding pixels 30s are different from that of other normal pixels 30 due to the influence of the phase difference detection pixels 40, it is possible to mitigate the influence.

5. Third Embodiment (Pixel Array Unit of 3 × 3 Pixels)

Fig. 14 is a diagram illustrating a configuration example of the pixel array unit 21 according to a third embodiment of the present disclosure.

A, B, and C in Fig. 14 respectively illustrate top views of the pixel regions 21H, 21V, and 21HV located toward ends of the image height away from the center position in a light receiving surface of the pixel array unit 21, that is, the center of the image height.

As illustrated in Fig. 14, in the pixel regions 21H, 21V, and 21HV, a pixel group including color filters for the same color is a pixel group of 3 × 3 pixels.

In a manner similar to the pixel array unit 21 including pixel groups of 2 × 2 pixels, the phase difference detection pixels 40 are included in addition to the normal pixels 30 in all of the pixel regions 21H, 21V, and 21HV illustrated in Fig. 14.

In each of the pixel regions 21H, 21V, and 21HV illustrated in Fig. 14, the image-height-dependent light shielding portion (first light shielding film LS1 or second light shielding film LS2) is provided not only to the pixel groups not including the surrounding pixels 30s but also to the pixel groups including the surrounding pixels 30s. Note that the image-height-dependent light shielding portion (first light shielding film LS1 or second light shielding film LS2) is not provided to the phase difference detection pixels 40.

According to the above configuration, even in the pixel array unit 21 including pixel groups of 3 × 3 pixels, it is possible to suppress the sensitivity difference between a pixel group including the surrounding pixels 30s and surrounding pixel groups of the same color not including the surrounding pixels 30s. As a result, it is possible to prevent a pixel group including the surrounding pixels 30s from being detected as a bright spot having a larger light amount than the other pixel groups.

6. Fourth Embodiment (Pixel Array Unit of 4 × 4 Pixels)

Fig. 15 is a diagram illustrating a configuration example of the pixel array unit 21 according to a fourth embodiment of the present disclosure.

A, B, and C in Fig. 15 respectively illustrate top views of the pixel regions 21H, 21V, and 21HV located toward ends of the image height away from the center position in a light receiving surface of the pixel array unit 21, that is, the center of the image height.

As illustrated in Fig. 15, in the pixel regions 21H, 21V, and 21HV, a pixel group including color filters for the same color is a pixel group of 4 × 4 pixels.

In a manner similar to the pixel array unit 21 including pixel groups of 2 × 2 pixels, the phase difference detection pixels 40 are included in addition to the normal pixels 30 in all of the pixel regions 21H, 21V, and 21HV illustrated in Fig. 15. However, in the example in Fig. 15, four pairs of two adjacent phase difference detection pixels 40 are provided so as to be accommodated in one pixel group (green pixel group).

In each of the pixel regions 21H, 21V, and 21HV illustrated in Fig. 15, the image-height-dependent light shielding portion (first light shielding film LS1 or second light shielding film LS2) is provided not only to the pixel groups not including the surrounding pixels 30s but also to the pixel groups including the surrounding pixels 30s. Note that the image-height-dependent light shielding portion (first light shielding film LS1 or second light shielding film LS2) is not provided to the phase difference detection pixels 40 or to the pixel groups including the phase difference detection pixels 40.

According to the above configuration, even in the pixel array unit 21 including pixel groups of 4 × 4 pixels, it is possible to suppress the sensitivity difference between a pixel group including the surrounding pixels 30s and surrounding pixel groups of the same color not including the surrounding pixels 30s. As a result, it is possible to prevent a pixel group including the surrounding pixels 30s from being detected as a bright spot having a larger light amount than the other pixel groups.

7. Fifth Embodiment (Configuration Including Waveguide)

Fig. 16 is a diagram illustrating a configuration example of the pixel array unit 21 according to a fifth embodiment of the present disclosure.

Fig. 16 illustrates a cross-sectional view of a pixel 30G included in a green pixel group and a pixel 30R included in a red pixel group adjacent to the pixel 30R.

In the example in Fig. 16, a waveguide 131 is formed between the color filter 32 of the pixel 30G and the color filter 32 of the pixel 30G so as to penetrate the photoelectric conversion units 34 from the on-chip lens layers LE. The waveguide 131 functions as the inter-pixel light shielding structure 33 described above, and is constituted by, for example, SiN, $SiO_2$, SiON, a styrene-based resin material, an acrylic-based resin material, a styrene-acrylic-copolymer-based resin material, a siloxane-based resin material, or the like.

A protective film 132 for protecting the waveguide 131 is formed around the waveguide 131. In addition, metal films 133 and 134 as a light shielding portion to which the technology according to the present disclosure can be applied are formed immediately below the waveguide 131 (on the photoelectric conversion unit 34 side). The metal films 133 and 134 are made of Ti, TiN, W, or the like, and function as an absorber that absorbs light incident from the outside.

According to the above configuration, an incident path of light incident on each pixel constituting the pixel array unit 21 is determined, and thus it is possible to suppress color mixing between pixels at the boundary between pixel groups including color filters for different colors.

8. Sixth Embodiment (Configuration for Increasing Sensitivity of Green Pixel Group)

Fig. 17 is a diagram illustrating a configuration example of the pixel array unit 21 according to a sixth embodiment of the present disclosure.

A, B, and C in Fig. 17 respectively illustrate top views of the pixel regions 21H, 21V, and 21HV located toward ends of the image height away from the center position in a light receiving surface of the pixel array unit 21 including pixel groups of 2 × 2 pixels, that is, the center of the image height.

As illustrated in Fig. 17, among the green pixel groups PG_G in each of the pixel regions 21H, 21V, and 21HV, the green pixel group PG_G in which the thickness of a light shielding wall (inter-pixel light shielding structure 33) formed for the four pixels constituting the green pixel group PG_G is adjusted to be thin is illustrated with gray coloring.

Specifically, in the pixel region 21H located horizontally away from the position of the center of the image height of the pixel array unit 21, the light shielding wall for the pixels constituting the green pixel group PG_G adjacent to the red pixel group PG_R in the row direction is adjusted to be thin.

In addition, in the pixel region 21V located vertically away from the position of the center of the image height of the pixel array unit 21, the light shielding wall for the pixels constituting the green pixel group PG_G adjacent to a blue pixel group PG_B in the row direction is adjusted to be thin.

Further, in the pixel region 21HV located diagonally away from the position of the center of the image height of the pixel array unit 21, the light shielding walls for the pixels constituting all of the green pixel groups PG_G are adjusted to be thin.

Fig. 18 is a diagram illustrating a cross-sectional configuration example of the pixel region 21H illustrated in Fig. 17 taken along line segment a-a'.

As illustrated in Fig. 18, a light shielding wall 151GG between the pixels constituting the green pixel group PG_G is formed to be thinner than a light shielding wall 151RR between the pixels constituting the red pixel group PG_R. Further, light shielding walls 151GR and 151RG between the pixel constituting the green pixel group PG_G and the pixel constituting the red pixel group PG_R are formed to be thin on the side corresponding to the pixel constituting the green pixel group PG_G. Note that the light shielding wall 151GR corresponds to the second light shielding film LS2 described above.

According to the above configuration, by adjusting the light shielding walls for the pixels constituting the green pixel group to be thin depending on the direction from the center of the image height of the pixel array unit 21, it is possible to increase the sensitivity of the green pixel group, which tends to decrease in sensitivity.

Fig. 19 is a diagram illustrating another cross-sectional configuration example of the pixel region 21H illustrated in Fig. 17 taken along line segment a-a'.

In the example in Fig. 19, not only the light shielding walls formed for the pixels constituting the green pixel group PG_G but also a rear deep trench isolation (RDTI) for isolating the photoelectric conversion units 34 of the pixels from each other is formed to be thin.

Specifically, as illustrated in Fig. 19, an RDTI 152GG between the pixels constituting the green pixel group PG_G is formed to be thinner than an RDTI 152RR between the pixels constituting the red pixel group PG_R. In addition, RDTIs 152GR and 152RG between the pixel constituting the green pixel group PG_G and the pixel constituting the red pixel groups PG_R are formed to be thin on the side corresponding to the pixel constituting the green pixel group PG_G.

According to the above configuration, by adjusting the light shielding walls and the RDTIs of the pixels constituting the green pixel group to be thin depending on the direction from the center of the image height of the pixel array unit 21, it is possible to increase the sensitivity of the green pixel group, which tends to decrease in sensitivity.

Note that the embodiments described above can be combined as appropriate.

The technology according to the present disclosure can be applied to light detection elements in general, including a distance measuring sensor that measures a distance, which is also referred to as a time of flight (ToF) sensor, in addition to the solid-state imaging device as the CMOS image sensor described above. The distance measuring sensor is a sensor that emits illumination light toward an object, detects reflected light returned upon reflection of the illumination light by a surface of the object, and calculates the distance to the object based on the time of flight from when the illumination light is emitted to when the reflected light is received. As a pixel structure for the distance measuring sensor, the structure of the pixel array unit 21 described above can be adopted.

The effects described in the present specification are mere examples and are not limiting. There may be other effects.

In addition, embodiments to which the technology according to the present disclosure is applied are not limited to the above-described embodiments, and various modifications can be made without departing from the gist of the technology according to the present disclosure.

Furthermore, the present disclosure can have the following configurations.

(1) A light detection element including

a pixel array unit formed by an arrangement of pixels that constitute, for every n × n pixels (n is a natural number of two or more), a pixel group including color filters of the same color,
two or more phase difference detection pixels adjacent to each other, the two or more phase difference detection pixels being provided in place of some of normal pixels arranged in the pixel array unit, and
a light shielding portion provided for each of the pixel groups constituted by the normal pixels, including surrounding pixels disposed around the phase difference detection pixels, the light shielding portion differing in width or shape depending on an image height.

(2) The light detection element according to (1), wherein
the light shielding portion is not provided to the phase difference detection pixels.
(3) The light detection element according to (2), wherein
the light shielding portion is not provided to the pixel groups including the phase difference detection pixels.
(4) The light detection element according to any of (1) to (3), including
an on-chip lens layer including a shared on-chip lens formed for every two or more adjacent ones of the phase difference detection pixels and an individual on-chip lens formed for each of the normal pixels, including the surrounding pixel.
(5) The light detection element according to (4), wherein
a boundary between the individual on-chip lenses formed in the normal pixels and the shared on-chip lens formed in the phase difference detection pixels is substantially quadrangular or substantially hexagonal.
(6) The light detection element according to (4) or (5), wherein
two or more adjacent ones of the phase difference detection pixels include the color filters of green.
(7) The light detection element according to (4) or (5), wherein
two or more adjacent ones of the phase difference detection pixels are provided to be accommodated in one of the pixel groups.
(8) The light detection element according to any of (4) to (7), wherein
a first pixel group including the surrounding pixels is provided with the light shielding portion having a light shielding characteristic different from that in a second pixel group present at the same image height and not including the surrounding pixels.
(9) The light detection element according to (8), wherein
the light shielding portion provided to the first pixel group has a light shielding characteristic corresponding to an output characteristic of the surrounding pixels.
(10) The light detection element according to any of (4) to (9), wherein
the light shielding portion includes an opening portion formed, for each of the pixel groups, in an upper layer relative to a photoelectric conversion unit included in each pixel constituting the pixel group, the opening portion differing in ratio of side lengths and shape depending on the image height.

(11) The light detection element according to (10), wherein
the light shielding portion is formed in the pixel group including the color filters of green.
(12) The light detection element according to (10) or (11), wherein
the ratio of side lengths is adjusted for each color of the color filters of an adjacent pixel group adjacent to the pixel group.
(13) The light detection element according to any of (10) to (12), wherein
the light shielding portion is formed between the on-chip lens layer and the photoelectric conversion unit.
(14) The light detection element according to any of (10) to (13), wherein
the number of sides forming the opening portion differs depending on the image height.
(15) The light detection element according to any of (10) to (13), wherein
the shape and an opening ratio of the opening portion differ depending on the image height.
(16) The light detection element according to any of (10) to (13), wherein
an opening ratio of the opening portion is maintained, and only the shape of the opening portion differs depending on the image height.
(17) The light detection element according to (4) to (9), wherein
in one of the pixel groups, the light shielding portion is formed in the normal pixels located far from a center of the image height, among the normal pixels adjacent to another of the pixel groups.
(18) The light detection element according to (17), wherein
in the pixel group including the color filters of red, the light shielding portion is formed in the normal pixels adjacent to the pixel group including the color filters of green.
(19) The light detection element according to (18), wherein
the light shielding portion is formed to extend along a boundary with the pixel group including the color filters of green.
(20) The light detection element according to any of (17) to (19), wherein
the light shielding portion is formed between the on-chip lens layer and a photoelectric conversion unit included in each pixel constituting the pixel group.

Reference Signs List

10 CMOS image sensor, 21 Pixel array unit, 30 Normal pixel, 30s Surrounding pixels, 31 Individual on-chip lens, 32 Color filter, 33 Inter-pixel light shielding structure, 34 Photoelectric conversion unit, 40 Phase difference detection pixel, 41 Shared on-chip lens, 101 Opening portion, 131 Waveguide, 151GG, 151GR, 151RG Light shielding wall, 152GG, 152GR, 152RG RDTI, LS1, First light shielding film, LS2 Second light shielding film

**Claims**

1.  A light detection element comprising:

    a pixel array unit formed by an arrangement of pixels that constitute, for every n × n pixels (n is a natural number of two or more), a pixel group including color filters of the same color;
    two or more phase difference detection pixels adjacent to each other, the two or more phase difference detection pixels being provided in place of some of normal pixels arranged in the pixel array unit; and
    a light shielding portion provided for each of the pixel groups constituted by the normal pixels, including surrounding pixels disposed around the phase difference detection pixels, the light shielding portion differing in width or shape depending on an image height.

2.  The light detection element according to claim 1, wherein
    the light shielding portion is not provided to the phase difference detection pixels.

3.  The light detection element according to claim 2, wherein
    the light shielding portion is not provided to the pixel groups including the phase difference detection pixels.

4.  The light detection element according to claim 1, comprising:
    an on-chip lens layer including a shared on-chip lens formed for every two or more adjacent ones of the phase difference detection pixels and an individual on-chip lens formed for each of the normal pixels, including the surrounding pixel.

5.  The light detection element according to claim 4, wherein

a boundary between the individual on-chip lenses formed in the normal pixels and the shared on-chip lens formed in the phase difference detection pixels is substantially quadrangular or substantially hexagonal.

6. The light detection element according to claim 4, wherein
two or more adjacent ones of the phase difference detection pixels include the color filters of green that are provided.

7. The light detection element according to claim 4, wherein
two or more adjacent ones of the phase difference detection pixels are provided to be accommodated in one of the pixel groups.

8. The light detection element according to claim 4, wherein
a first pixel group including the surrounding pixels is provided with the light shielding portion having a light shielding characteristic different from that in a second pixel group present at the same image height and not including the surrounding pixels.

9. The light detection element according to claim 8, wherein
the light shielding portion provided to the first pixel group has a light shielding characteristic corresponding to an output characteristic of the surrounding pixels.

10. The light detection element according to claim 4, wherein
the light shielding portion includes an opening portion formed, for each of the pixel groups, in an upper layer relative to a photoelectric conversion unit included in each pixel constituting the pixel group, the opening portion differing in ratio of side lengths and shape depending on the image height.

11. The light detection element according to claim 10, wherein
the light shielding portion is formed in the pixel group including the color filters of green.

12. The light detection element according to claim 10, wherein
the ratio of side lengths is adjusted for each color of the color filters of an adjacent pixel group adjacent to the pixel group.

13. The light detection element according to claim 10, wherein
the light shielding portion is formed between the on-chip lens layer and the photoelectric conversion unit.

14. The light detection element according to claim 10, wherein
the number of sides forming the opening portion differs depending on the image height.

15. The light detection element according to claim 10, wherein
the shape and an opening ratio of the opening portion differ depending on the image height.

16. The light detection element according to claim 10, wherein
an opening ratio of the opening portion is maintained, and only the shape of the opening portion differs depending on the image height.

17. The light detection element according to claim 4, wherein
in one of the pixel groups, the light shielding portion is formed in the normal pixels located far from a center of the image height, among the normal pixels adjacent to another of the pixel groups.

18. The light detection element according to claim 17, wherein
in the pixel group including the color filters of red, the light shielding portion is formed in the normal pixels adjacent to the pixel group including the color filters of green.

19. The light detection element according to claim 18, wherein
the light shielding portion is formed to extend along a boundary with the pixel group including the color filters of green.

20. The light detection element according to claim 17, wherein
the light shielding portion is formed between the on-chip lens layer and a photoelectric conversion unit included in each pixel constituting the pixel group.

# Fig.1

ROW DIRECTION

COLUMN DIRECTION

PIXEL ARRAY UNIT ~21

26

10

22~ VERTICAL DRIVE UNIT

25~ SYSTEM CONTROL UNIT

COLUMN PROCESSING UNIT ~23

~27

HORIZONTAL DRIVE UNIT

24

DATA STORAGE UNIT 29

SIGNAL PROCESSING UNIT

28

Fig.2

EP 4 697 384 A1

# Fig.3

# Fig.4

# Fig.5

31

41

# Fig.6

# Fig.7

# Fig.8

# Fig.9

101

LS1

# F i g . 1 0

21

PG-1

PG-2

LS1-2

101-2

LS1-1

101-1

# Fig.11

# Fig.12

Fig. 13

# Fig.14

Fig. 15

# Fig.16

Fig.17

A  B  C

EP 4 697 384 A1

# Fig.18

EP 4 697 384 A1

# Fig.19

## INTERNATIONAL SEARCH REPORT

| International application No. |
|---|
| **PCT/JP2024/011880** |

| | | |
|---|---|---|
| **A.** | **CLASSIFICATION OF SUBJECT MATTER** | |

*H01L 27/146*(2006.01)i; *G02B 5/20*(2006.01)i
FI:  H01L27/146 D; G02B5/20 101

According to International Patent Classification (IPC) or to both national classification and IPC

| **B.** | **FIELDS SEARCHED** |
|---|---|

Minimum documentation searched (classification system followed by classification symbols)

H01L27/146; G02B5/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| Y | JP 2019-29985 A (SONY SEMICONDUCTOR SOLUTIONS CORPORATION) 21 February 2019 (2019-02-21) paragraphs [0019]-[0079], fig. 1-4 | 1, 4-7, 10-20 |
| A | | 2, 3, 8, 9 |
| Y | JP 2017-59739 A (SONY SEMICONDUCTOR SOLUTIONS CORPORATION) 23 March 2017 (2017-03-23) paragraphs [0008]-[0015], fig. 5-18 | 1, 4-7, 10-20 |
| Y | WO 2016/098640 A1 (SONY CORPORATION) 23 June 2016 (2016-06-23) fig. 3-7 | 5 |
| Y | JP 2008-312073 A (NIKON CORPORATION) 25 December 2008 (2008-12-25) fig. 16, 17 | 7 |
| A | JP 2022-106151 A (SONY SEMICONDUCTOR SOLUTIONS CORPORATION) 19 July 2022 (2022-07-19) | 1-20 |

| ✓ Further documents are listed in the continuation of Box C. | ✓ See patent family annex. |
|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **17 May 2024** | **28 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**EP 4 697 384 A1**

## INTERNATIONAL SEARCH REPORT

International application No.

**PCT/JP2024/011880**

### C. DOCUMENTS CONSIDERED TO BE RELEVANT

| Category* | Citation of document, with indication, where appropriate, of the relevant passages | Relevant to claim No. |
|---|---|---|
| A | JP 2010-199668 A (SONY CORPORATION) 09 September 2010 (2010-09-09) | 1-20 |
| A | JP 2022-114386 A (SONY SEMICONDUCTOR SOLUTIONS CORPORATION) 05 August 2022 (2022-08-05) | 1-20 |

Form PCT/ISA/210 (second sheet) (July 2022)

34

### INTERNATIONAL SEARCH REPORT
**Information on patent family members**

| International application No. |
| PCT/JP2024/011880 |

| Patent document cited in search report | | | Publication date (day/month/year) | Patent family member(s) | | | Publication date (day/month/year) |
|---|---|---|---|---|---|---|---|
| JP | 2019-29985 | A | 21 February 2019 | US | 2020/0161352 | A1 | |
| | | | | paragraphs [0057]-[0118], fig. 1-4 | | | |
| | | | | EP | 3662513 | A1 | |
| | | | | CN | 110770906 | A | |
| | | | | KR | 10-2020-0033802 | A | |
| | | | | WO | 2019/026718 | A1 | |
| JP | 2017-59739 | A | 23 March 2017 | US | 2018/0160058 | A1 | |
| | | | | paragraphs [0011]-[0018], fig. 5-18 | | | |
| | | | | WO | 2017/047039 | A1 | |
| WO | 2016/098640 | A1 | 23 June 2016 | US | 2017/0366770 | A1 | |
| | | | | fig. 3-7 | | | |
| | | | | EP | 3236500 | A1 | |
| | | | | CN | 107004685 | A | |
| | | | | KR | 10-2017-0098809 | A | |
| JP | 2008-312073 | A | 25 December 2008 | US | 2010/0091161 | A1 | |
| | | | | fig. 16, 17 | | | |
| | | | | WO | 2008/156049 | A1 | |
| | | | | EP | 2164269 | A1 | |
| JP | 2022-106151 | A | 19 July 2022 | WO | 2022/149399 | A1 | |
| JP | 2010-199668 | A | 09 September 2010 | US | 2010/0214454 | A1 | |
| | | | | 1-20 | | | |
| | | | | EP | 2222077 | A2 | |
| | | | | CN | 101814517 | A | |
| | | | | KR | 10-2010-0096003 | A | |
| | | | | TW | 201103340 | A | |
| JP | 2022-114386 | A | 05 August 2022 | WO | 2022/163296 | A1 | |

Form PCT/ISA/210 (patent family annex) (July 2022)

**REFERENCES CITED IN THE DESCRIPTION**

**Patent documents cited in the description**

- JP 2017059739 A

- JP 2023002902 A